(19) **Europäisches Patentamt**
**European Patent Office**
**Office européen des brevets**

(11) **EP 2 838 205 A2**

(12) **EUROPEAN PATENT APPLICATION**

(43) Date of publication:
    **18.02.2015 Bulletin 2015/08**

(51) Int Cl.:
    ***H04B 1/12*** (2006.01)

(21) Application number: **14180219.9**

(22) Date of filing: **07.08.2014**

(84) Designated Contracting States:
    **AL AT BE BG CH CY CZ DE DK EE ES FI FR GB GR HR HU IE IS IT LI LT LU LV MC MK MT NL NO PL PT RO RS SE SI SK SM TR**
    Designated Extension States:
    **BA ME**

(30) Priority: **13.08.2013 US 201313965655**

(71) Applicant: **Intel IP Corporation**
    **Santa Clara, CA 95054 (US)**

(72) Inventors:
    • **Arditti Ilitzky, David**
      **JAL 44600 Guadalajara (MX)**

• **Alcocer Ochoa, Alberto**
  **JAL 45601 Zapopan (MX)**
• **Kontorovich Mazover, Valeri**
  **DIF 07360 Mexico City (MX)**
• **Ramos Alarcon Barroso, Fernando**
  **Santa Clara, CA 95054 (US)**

(74) Representative: **Goddar, Heinz J.**
    **Boehmert & Boehmert**
    **Anwaltspartnerschaft mbB**
    **Patentanwälte Rechtsanwälte**
    **Pettenkoferstrasse 20-22**
    **80336 München (DE)**

(54) **Adaptive mitigation of platform-generated radio-frequency Interference**

(57)     Described are methods and systems for mitigating radio-frequency interference (RFI) generated by a receiving platform. After downconverting a received RF signal to baseband, the RFI component in the baseband signal may be estimated using a model-based estimator (e.g., a nonlinear filter such as an extended Kalman filter) that is tuned to a statistical model of the RFI source. The estimated RFI component may then be subtracted from the baseband signal to yield a compensated baseband signal from which may be extracted the baseband information signal. This filtering technique enables a highly accurate mitigation of the RFI even when the RFI power is much smaller compared to the Gaussian channel noise.

Fig. 4

**Description**

BACKGROUND

Wireless receiving platforms such as personal computers, mobile phones, and other handheld devices are computerized devices that demodulate and process received wireless signals in the digital domain. Such digital processing involves the operation of high-speed digital signaling components such as clocks and busses that may act as sources of platform-generated radio-frequency (RF) interference, referred to herein as RFI. The platform-generated RF interference acts as additive noise when it is combined with a received signal at the receiver's antenna port. Noise reduction techniques employed in typical receivers are optimized for handling a mixture of a desired signal and additive white Gaussian noise (AWGN). Platform-generated RF noise coming from multiple simultaneous sources, however, has been found through measurements to be significantly non-Gaussian and may also be non-stationary with different short-term behaviors. This type of noise significantly degrades the performance of typical wireless receivers, especially in small form factors where antennas are closer to the RFI sources. Common mitigation techniques provide limited results as they are not well-suited for removing platform-generated noise due to its typically non-stationary and non-Gaussian nature. When a received signal is mixed with such noise, the performance of the receiver may be heavily degraded up to the point of completely blocking the communication. This problem is aggravated as receiving platforms incorporate higher levels of integration, higher data rates, and smaller form factors.

BRIEF DESCRIPTION OF THE DRAWINGS

Fig. 1 shows an example wireless platform configured to perform RFI mitigation.
Fig. 2 shows an example of an RFI mitigation block for stationary RFI.
Fig. 3 shows an example of an RFI mitigation block for non-stationary RFI that employs a model selector for tuning the model-based estimator.
Fig. 4 shows an example of an RFI mitigation block for non-stationary RFI that employs partial classification of the incoming RFI for model selection.

DETAILED DESCRIPTION

The following description and the drawings sufficiently illustrate specific embodiments to enable those skilled in the art to practice them. Other embodiments may incorporate structural, logical, electrical, process, and other changes. Portions and features of some embodiments may be included in, or substituted for, those of other embodiments. Embodiments set forth in the claims encompass all available equivalents of those claims.

An RF signal r(t) received at the antenna of a wireless receiving platform may be regarded as a superposition of a band-limited upconverted information signal s(t), channel noise n(t) (i.e., AWGN), and platform generated RFI i(t). That is, the received signal r(t) may be expressed as:

$$r(t) = s(t) + n(t) + i(t)$$

Under a narrowband assumption implying an ideal downconverter tuned to the limited bandwidth of s(t), the received signal after downconversion and digitization, designated as baseband signal B(k), is the superposition of the complex envelopes of each of the constituent signals. Designating the downconverted and digitized received signal as baseband signal B(k):

$$B(k) = S(k) + N(k) + I(k)$$

where S(k), N(k), and I(k) are the discrete-time complex envelopes of s(t), n(t), and i(t), respectively. The received signal r(t) may be mixed down using carrier frequencies in phase quadrature to generate in-phase and quadrature components at the digital baseband that correspond to the real and imaginary components of the baseband signal's complex envelope, designated as $B_R(k)$ and $B_I(k)$, respectively.

Described below are methods and systems for mitigating the platform generated RFI by estimating the RFI component I(k) in the composite baseband signal using a model-based estimator (e.g., a nonlinear filter such as an extended Kalman filter) that is tuned to a statistical model of the RFI source. The estimated RFI component I(k) may then be subtracted from the baseband signal to yield a compensated baseband signal from which may be extracted the baseband information signal S(k). This filtering technique enables a highly accurate mitigation of the RFI even when the RFI power is much smaller compared to the Gaussian channel noise. It should also be noted that, because the model-based estimator essentially regards the information signal S(k) as noise in relation to the RFI signal I(k), the RFI mitigation performance actually improves as the interference signal power increases.

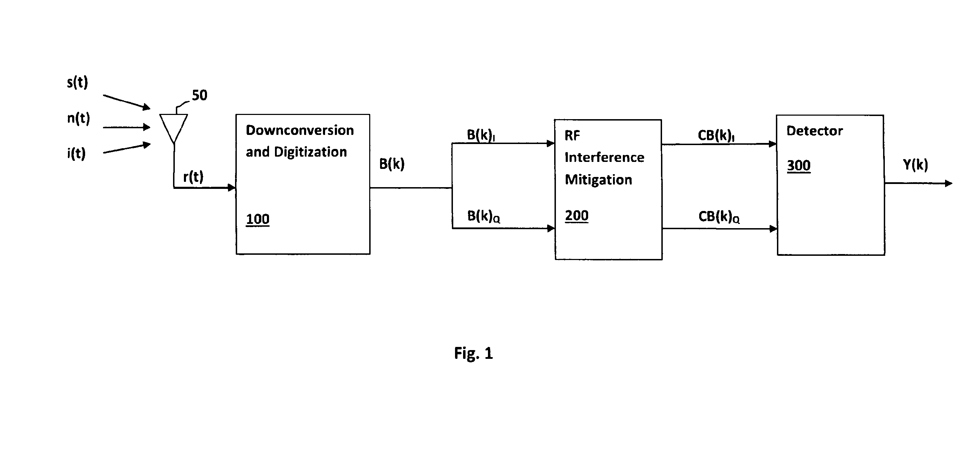

Fig. 1 illustrates a receiving platform configured to perform platform generated RFI mitigation according to one embodiment. A wireless signal r(t) is received at antenna 50, where the signal r(t) is a superposition of an information bearing signal s(t), channel noise n(t), and platform-generated RF interference. The signal s(t) may be a carrier waveform modulated with an information signal using a digital modulation scheme such as QAM (quadrature amplitude modulation), OFDM (orthogonal frequency division multiplexing), SC-FDM (single-carrier frequency division multiplexing), and CDM (code division multiplexing). The received signal r(t) is downconverted to baseband and digitized by downconverter and digitizer 100 to generate a discrete baseband signal B(k). The signal B(k) may be made up of complex-valued samples with real and imaginary parts represented by in-phase and quadrature components, $B_I(k)$ and $B_Q(k)$, respectively. The baseband signal B(k) is next input to baseband processing circuitry that includes an RF interference mitigation block 200 and a detector or demodulator 300. The RF interference mitigation block uses a model-based estimator and a statistical model of the platform-generated interference to estimate the platform-generated interference E(k) present in the baseband signal baseband signal B(k) and subtracts it therefrom to generate compensated baseband signal CB(k). The compensated baseband signal CB(k) is then processed by detector 300 to extract the information signal as symbols Y(k). Embodiments are described below for dealing with the special case of stationary platform generated RFI and for mitigating the more general case of non-stationary RFI.

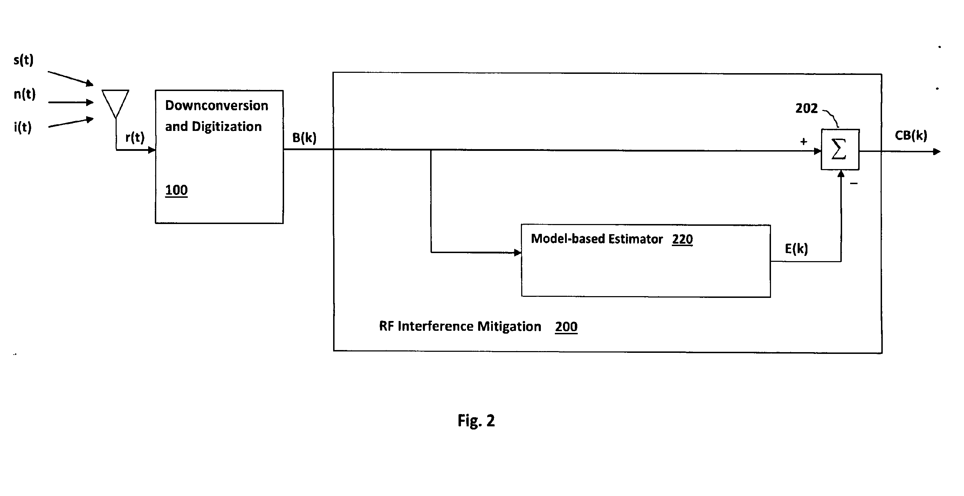

In one embodiment, a model of the platform-generated RFI for use in RFI mitigation is generated by operating the receiving platform while capturing the RF energy emitted at the platform's antenna port in the absence of any other signals. The captured RF energy then reflects only the platform-generated RFI. The statistical properties of the downconverted and digitized captured RF energy may then be analyzed in order to construct a model of the RFI. For example, the model of downconverted RFI may be made to fit the probability density function (PDF) and/or auto-covariance function (ACF) of the downconverted RFI. In the special case where the RFI source or sources in the receiving platform may be regarded as stationary processes (i.e., the dynamics or statistics of the process do not change significantly over time), only one such RFI model needs to be constructed, either by a synthesis procedure or by selecting from a library of predefined models. In that case, the RF interference block 200 may be as depicted in Fig. 2 where the model-based estimator 220 uses the RFI model to generate an estimate E(k) of the platform generated interference present in the baseband signal. The interference estimate E(k) is subtracted from the baseband signal B(k) at summer 202 to generate the compensated baseband signal CB(k). In one embodiment, the statistical model of the downconverted RFI is a chaotic model where the modeling of the RFI performed by means of chaotic signals generated by corresponding chaotic strange attractors. In other embodiments, the RFI model is a stochastic (e.g., Markovian) model based upon stochastic differential equations. A digital nonlinear filter tuned to the derived RFI statistics may then accurately estimate and remove the platform generated RFI from the baseband signal. In various embodiments, the non-

linear filter or model-based estimator may be, for example, an extended Kalman filter, an unscented Kalman filter, a sliding-mode observer, or an exponentially weighted recursive least-squares filter.

In most situations, platform-generated RFI is non-stationary because it is produced by multiple high speed digital signaling sources (e.g., clocks and buses) with varying dynamics. For example, the sources may be in idle or active states and may operate at different stress levels. These different RFI sources may act simultaneously where, in general, each RFI source constitutes a statistically distinct process. When the sources are added together, a composite non-stationary (in the short-term sense) process with multiple (but finite) different short-term behaviors is the result. That is, the platform-generated RF interference signal represents the superposition of multiple interference signals generated at different sources which may or may not be present at any given time. The RFI may thus be expressed as:

$$i(t) = \sum i_k(t) \cdot g_k(t)$$

where $g_k(t)$ is a gating function for the kth interferer signal. These short-term behaviors are generally non-Gaussian and correlated. To deal with this situation, in one embodiment, a system adapts the filtering of platform-generated RFI to each short-term behavior separately and continuously keeps track of which behavior is being observed. The RFI may then be filtered out in the digital baseband using nonlinear digital signal processing based on switched models (e.g., chaotic models). Non-stationary platform generated RFI may be modeled by constructing a plurality of stochastic or chaotic models, each of which reflects one of a finite number of possible short-term statistical behaviors of the down-converted platform generated RFI. The models may be created in a manner similar to that described above for the stationary RFI case where the platform is operated in the absence of a received signal and the resulting RF energy is captured and statistically analyzed. For non-stationary RFI, however, the platform is sequenced through a number of operating modes in order to exhibit a number of statistically different RFI behaviors. For each such short-term RFI behavior, a model is constructed (e.g., by synthesis or selection from library of available models) to fit the statistical properties (e.g., the probability density function (PDF) and/or auto-covariance function (ACF)) obtained from analyzing the captured and downconverted RFI.

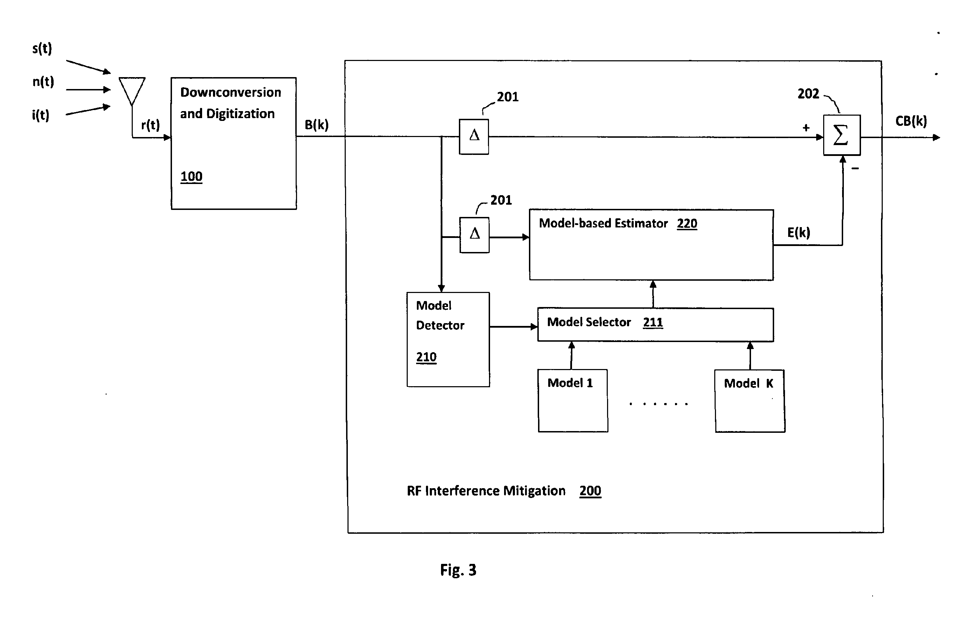

In one embodiment, a receiving platform configured to mitigate non-stationary platform generated RFI uses three main components: a set of different stochastic models (chaotic or Markovian) for the downconverted RFI, a model detector that employs detection rule(s) to select which model best fits the behavior of current observations, and a nonlinear filter or model-based estimator that is tuned to the currently selected model. Based on higher-order statistics (or "cumulants") analysis to detect which of the known PDFs/ACFs is currently being observed or if the received signal is RFI free, the model detector selects the corresponding model to "tune" the model-based estimator. In the absence of RFI in the received signal, the model-based estimator may be disabled to then deliver the received baseband signal without modifications to the detector for demodulation. During operation the model detection process may be performed with some degree of latency. In order to avoid mitigation errors, delay elements may be employed in the received signal path in order to align in time the model selection with the incoming signal to the model-based estimator. The model-based estimator then extracts (i.e., continuously estimates) the interference so that it may be excised from the received signal. Fig. 3 illustrates an embodiment of the RF interference mitigation block 200 that uses a plurality of different statistical models to remove non-stationary platform-generated interference. Model detector 210 receives the baseband signal B(k) and, based upon statistical characteristics of the baseband signal, selects one of a plurality of models for use in tuning the model-based estimator 220 via model selector 211. After one of the plurality of models Model 1 through Model K is selected, the model-based estimator generates an estimate E(k) of the platform generated interference present in the baseband signal. The interference estimate E(k) is subtracted from the baseband signal B(k) at summer 202 to generate the compensated baseband signal CB(k). Delay elements 201 are used to delay and time-align the baseband signal arriving at the model-based estimator 220 and summer 202 and provide time for the model selector to process the baseband signal.

In certain situations, it may be the case that the nature of the platform generated RFI is such that it is not possible to create a model detector that is able, based upon an analysis of the received signal, to accurately detect which of a plurality models should be used for RFI mitigation. In those situations, it may be possible to employ instead a technique of partial classification for the received signal where a classifier capable of selecting sets or "classes" of models with similar characteristics is used in place of a model detector that selects a single model. In this case, the mitigation may occur in parallel mitigation branches, one for each model in the selected class, and a selection of the best fit in the class then performed by a simpler model detector that analyzes the output of each parallel branch rather than analyzing the statistics of the received baseband signal. For example, the simple model detector may compare the output variance of each branch and then selects the branch with smallest variance. The number of parallel mitigation branches may be made equal to the number of models in the class with higher cardinality. Depending on the selected class, some mitigation branches may be disabled or inactive (e.g., when the class contains fewer models than the quantity of available parallel branches).

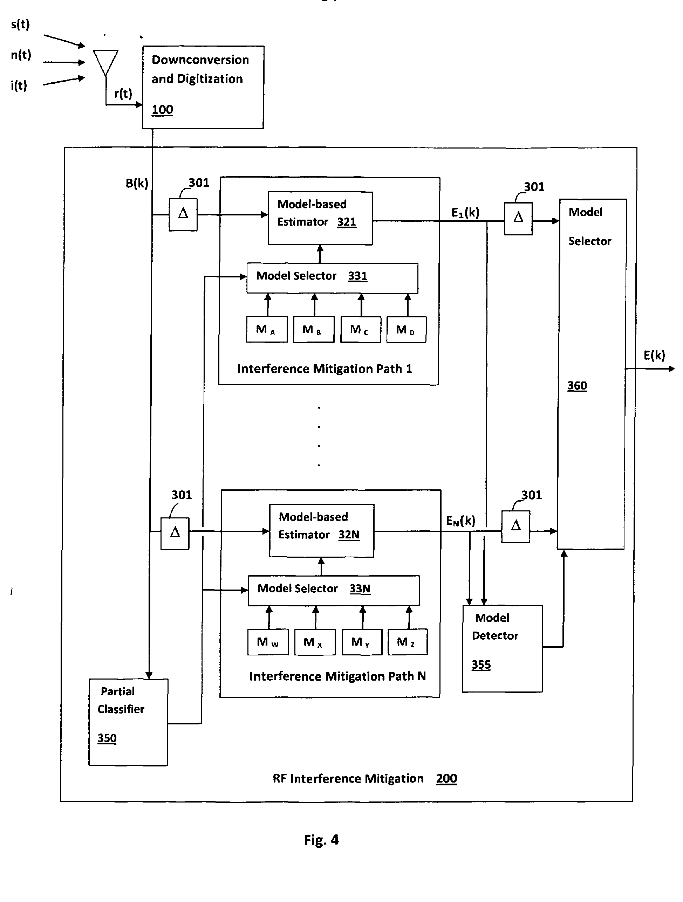

Fig. 4 illustrates an embodiment of the RF interference mitigation block 200 in which a partial classifier 350, based upon statistical characteristics of the baseband signal, classifies the RF interference of the baseband signal into a model class selected from a plurality of model classes, where each model class includes one or more models of the platform-generated RF interference. Based upon the selected model class, the baseband signal is passed through one or more interference mitigation paths in parallel where each such path includes a model-based estimator tuned to a model of the platform-generated RF interference belonging to the selected model class.

In Fig. 4, interference mitigation paths 1 through N may be selected by the partial classifier 350 so that the baseband signal is passed through a model-based estimator using each model of the selected model class. Interference mitigation path 1 incorporates model-based estimator 321, model selector 331, and models $M_A$ through $M_D$. Interference mitigation path N incorporates model-based estimator 32N, model selector 33N, and models $M_W$ through $M_Z$. Selection of a model class by the partial classifier thus entails selection of one or more interference mitigation path and a model belonging to each selected interference mitigation path. Model detector 335 compares the output variance of each interference mitigation path and selects the model of the platform-generated RF interference belonging to the interference path with the lowest output variance via model selector 360. The selected model-based estimator then generates an estimate E(k) of the platform generated interference present in the baseband signal that may be subtracted from the baseband signal B(k) to yield the compensated baseband signal CB(k).

In the embodiments described above, the various functions of the receiving platform, including RFI mitigation, may be implemented as discrete hardware components, as code executed by a processor, or any combinations thereof. As the term is used herein, "processing circuitry" should be taken to encompass any of those types of implementations. Also, in another embodiment, RFI mitigation may be performed as in any of the embodiments described above for RFI produced from a source other than the receiving platform. For example, to prevent a jamming attack, the statistical properties of the jamming device could be determined and a model or models of the jamming RFI created. The RFI mitigation would then be performed as in any in the above-described embodiments with a model-based estimator tuned to the selected model.

*Additional Notes and Examples*

In Example 1, a method comprises receiving a signal at a receiving platform that includes platform-generated radio-frequency (RF) interference and a carrier waveform modulated with an information signal; downconverting and digitizing the received signal to produce a baseband signal; generating an estimate of the platform-generated RF interference by filtering the baseband signal using a model-based estimator tuned to a statistical model of the platform-generated RF interference; and, subtracting the estimate of the platform-generated RF interference from the baseband signal to generate a compensated baseband signal that may be demodulated to extract the information signal.

In Example 2, the subject matter of Example 1 may optionally include demodulating the compensated baseband signal in the presence of additive white Gaussian noise in the received signal.

In Example 3, the subject matter of Example 1 may optionally include wherein the model-based estimator is a non-linear filter selected from a group that includes an extended Kalman filter, an unscented Kalman filter, and a sliding-mode observer.

In Example 4, the subject matter of Example 1 may optionally include wherein the model of the platform-generated interference is an at least partially chaotic model.

In Example 5, the subject matter of Example 1 may optionally include wherein the model of the platform-generated interference is at least partially based upon stochastic differential equations.

In Example 6, the subject matter of Example 1 may optionally include wherein the model of the platform-generated interference is pre-generated prior to receiving the signal by: operating the receiving platform while no carrier waveform is being received; capturing at the receiving platform's antenna port the RF energy emitted during operation of the receiving platform; and, deriving a model for the platform-generated RF interference based upon statistical characteristics of the captured RF energy.

In Example 7, the subject matter of Example 1 may optionally include selecting one of a plurality of stored models of the platform-generated RF interference for tuning the model-based estimator based upon statistical characteristics of the baseband signal.

In Example 8, the subject matter of Example 7 may optionally include wherein the plurality of stored models correspond to different operating modes of the receiving platform.

In Example 9, the subject matter of Example 7 may optionally include wherein the models of the platform-generated interference are pre-generated prior to receiving the signal by: operating the receiving platform in each of a plurality of modes while no carrier waveform is being received, wherein each mode corresponds to a different stress pattern for operating the receiving platform; for each of the modes, capturing at the receiving platform's antenna port the RF energy emitted by the receiving platform; and, for each of the modes, deriving a model for the platform-generated RF interference based upon statistical characteristics of the captured RF energy.

In Example 10, the subject matter of Example 1 may optionally include: based upon statistical characteristics of the baseband signal, classifying the platform-generated RF interference into a model class selected from a plurality of model classes, wherein each model class includes one or more models of the platform-generated RF interference; inputting the baseband signal into one or more interference mitigation paths in parallel where each such path includes a model-based estimator tuned to a model of the platform-generated RF interference belonging to the selected model class; comparing the output variance of each interference mitigation path; generating an estimate of the platform-generated RF interference by filtering the baseband signal using a model-based estimator tuned to the model of the platform-generated RF interference belonging to the interference mitigation path with the lowest output variance.

In Example 11, wireless receiving platform, comprises: circuitry including a mixer and sampling circuitry for downconverting a received signal to a baseband signal wherein the received signal includes platform-generated radio-frequency (RF) interference and carrier modulated with an information signal; and, processing circuitry to: generate an estimate of the platform-generated RF interference by filtering the baseband signal using a model-based estimator tuned to a statistical model of the platform-generated RF interference; subtract the estimate of the platform-generated RF interference from the baseband signal to generate a compensated baseband signal that may be demodulated to extract the information signal.

In Example 12, the subject matter of Example 11 may optionally include wherein the model-based estimator is a non-linear filter selected from a group that includes an extended Kalman filter, an unscented Kalman filter, and a sliding-mode observer.

In Example 13, the subject matter of Example 11 may optionally include wherein the model of the platform-generated interference is an at least partially chaotic model.

In Example 14, the subject matter of Example 11 may optionally include wherein the model of the platform-generated interference is at least partially based upon stochastic differential equations.

In Example 15, the subject matter of Example 11 may optionally include wherein the processing circuitry is further to demodulate the compensated baseband signal in the presence of additive white Gaussian noise in the received signal.

In Example 16, the subject matter of Example 11 may optionally include wherein the model of the platform-generated interference is pre-generated prior to receiving the signal by: operating the receiving platform; capturing at the receiving platform's antenna port the RF energy emitted during operation of the receiving platform; and, deriving a model for the platform-generated RF interference based upon statistical characteristics of the captured RF energy.

In Example 17, the subject matter of Example 11 may optionally include a model selector for selecting one of a plurality of stored models of the platform-generated RF interference for tuning the model-based estimator based upon statistical characteristics of the baseband signal.

In Example 18, the subject matter of Example 17 may optionally include wherein the plurality of stored models correspond to different operating modes of the receiving platform.

In Example 19, the subject matter of Example 17 may optionally include wherein the models of the platform-generated interference are pre-generated prior to receiving the signal by: operating the receiving platform in each of a plurality of modes while no carrier waveform is being received, wherein each mode corresponds to a different stress pattern for operating the receiving platform; for each of the modes, capturing at the receiving platform's antenna port the RF energy emitted by the receiving platform; and, for each of the modes, deriving a model for the platform-generated RF interference based upon statistical characteristics of the captured RF energy.

In Example 20, the subject matter of Example 11 may optionally include processing circuitry that includes: a partial classifier for, based upon statistical characteristics of the baseband signal, classifying the RF interference of the baseband signal into a model class selected from a plurality of model classes, wherein each model class includes one or more models of the platform-generated RF interference; circuitry for inputting the baseband signal into one or more interference mitigation paths in parallel where each such path includes a model-based estimator tuned to a model of the platform-generated RF interference belonging to the selected model class; a model detector for comparing the output variance of each interference mitigation path and selecting the model of the platform-generated RF interference belonging to the interference mitigation path with the lowest output variance, wherein the processing circuitry is to generate an estimate of the platform-generated RF interference by filtering the baseband signal using a model-based estimator tuned to the selected model of the platform-generated RF interference.

In Example 21, a machine-readable medium contains instructions that, when executed, cause a machine to carry out functions as recited by any of Examples 1 through 10.

In Example 22, a system comprises means for performing the functions as recited by any of Examples 1 through 10.

The embodiments as described above may be implemented as methods for operation and/or in various hardware configurations that may include a processor for executing instructions that perform the methods. Such instructions may be contained in a suitable storage medium from which they are transferred to a memory or other processor-executable medium.

The embodiments as described herein may be implemented in a number of environments such as part of a wireless local area network (WLAN), 3rd Generation Partnership Project (3GPP) Universal Terrestrial Radio Access Network (UTRAN), or Long-Term-Evolution (LTE) or a Long-Term-Evolution (LTE) communication system, although the scope of the invention is not limited in this respect. An example LTE system includes a number of mobile stations, defined by the LTE specification as User Equipment (UE), communicating with a base station, defined by the LTE specifications as eNode-B.

Antennas referred to herein may comprise one or more directional or omnidirectional antennas, including, for example, dipole antennas, monopole antennas, patch antennas, loop antennas, microstrip antennas or other types of antennas suitable for transmission of RF signals. In some embodiments, instead of two or more antennas, a single antenna with multiple apertures may be used. In these embodiments, each aperture may be considered a separate antenna. In some multiple-input multiple-output (MIMO) embodiments, antennas may be effectively separated to take advantage of spatial diversity and the different channel characteristics that may result between each of antennas and the antennas of a transmitting station. In some MIMO embodiments, antennas may be separated by up to 1/10 of a wavelength or more.

In some embodiments, a receiver as described herein may be configured to receive signals in accordance with specific communication standards, such as the Institute of Electrical and Electronics Engineers (IEEE) standards including IEEE 802.11-2007 and/or 802.11 (n) standards and/or proposed specifications for WLANs, although the scope of the invention is not limited in this respect as they may also be suitable to transmit and/or receive communications in accordance with other techniques and standards. In some embodiments, the receiver may be configured to receive signals in accordance with the IEEE 802.16-2004, the IEEE 802.16(e) and/or IEEE 802.16(m) standards for wireless metropolitan area networks (WMANs) including variations and evolutions thereof, although the scope of the invention is not limited in this respect as they may also be suitable to transmit and/or receive communications in accordance with other techniques and standards. In some embodiments, the receiver may be configured to receive signals in accordance with the Universal Terrestrial Radio Access Network (UTRAN) LTE communication standards.

The subject matter has been described in conjunction with the foregoing specific embodiments. It should be appreciated that those embodiments may also be combined in any manner considered to be advantageous. Also, many alternatives, variations, and modifications will be apparent to those of ordinary skill in the art. Other such alternatives, variations, and modifications are intended to fall within the scope of the following appended claims.

The Abstract is provided to comply with 37 C.F.R. Section 1.72(b) requiring an abstract that will allow the reader to ascertain the nature and gist of the technical disclosure. It is submitted with the understanding that it will not be used to limit or interpret the scope or meaning of the claims. The following claims are hereby incorporated into the detailed description, with each claim standing on its own as a separate embodiment.

**Claims**

1. A method, comprising:

   receiving a signal at a receiving platform that includes platform-generated radio-frequency (RF) interference and a carrier waveform modulated with an information signal;
   downconverting and digitizing the received signal to produce a baseband signal;
   generating an estimate of the platform-generated RF interference by filtering the baseband signal using a model-based estimator tuned to a statistical model of the platform-generated RF interference; and,
   subtracting the estimate of the platform-generated RF interference from the baseband signal to generate a compensated baseband signal.

2. The method of claim 1 wherein the model of the platform-generated interference is pre-generated prior to receiving the signal by:

   operating the receiving platform while no carrier waveform is being received;
   capturing at the receiving platform's antenna port the RF energy emitted during operation of the receiving platform; and,
   deriving a model for the platform-generated RF interference based upon statistical characteristics of the captured RF energy.

3. The method of claim 1 further comprising selecting one of a plurality of stored models of the platform-generated RF interference for tuning the model-based estimator based upon statistical characteristics of the baseband signal.

4. The method of claim 3 wherein the plurality of stored models correspond to different operating modes of the receiving platform.

5. The method of claim 3 wherein the models of the platform-generated interference are pre-generated prior to receiving the signal by:

   operating the receiving platform in each of a plurality of modes while no carrier waveform is being received, wherein each mode corresponds to a different stress pattern for operating the receiving platform;
for each of the modes, capturing at the receiving platform's antenna port the RF energy emitted by the receiving platform; and,
for each of the modes, deriving a model for the platform-generated RF interference based upon statistical characteristics of the captured RF energy.

6. The method of claim 1 further comprising:

   based upon statistical characteristics of the baseband signal, classifying the platform-generated RF interference into a model class selected from a plurality of model classes, wherein each model class includes one or more models of the platform-generated RF interference;
   inputting the baseband signal into one or more interference mitigation paths in parallel where each such path includes a model-based estimator tuned to a model of the platform-generated RF interference belonging to the selected model class;
   comparing the output variance of each interference mitigation path;
   generating an estimate of the platform-generated RF interference by filtering the baseband signal using a model-based estimator tuned to the model of the platform-generated RF interference belonging to the interference mitigation path with the lowest output variance.

7. A wireless receiving platform, comprising:

   circuitry including a mixer and sampling circuitry for downconverting and digitizing a received signal to a baseband signal wherein the received signal includes platform-generated radio-frequency (RF) interference and carrier modulated with an information signal; and,
   processing circuitry to :

      generate an estimate of the platform-generated RF interference by filtering the baseband signal using a model-based estimator tuned to a statistical model of the platform-generated RF interference;
      subtract the estimate of the platform-generated RF interference from the baseband signal to generate a compensated baseband signal; and,
      extract the information signal from the compensated baseband signal.

8. The wireless receiving platform of claim 7 wherein the model-based estimator is a non-linear filter selected from a group that includes an extended Kalman filter, an unscented Kalman filter, and a sliding-mode observer.

**9.** The wireless receiving platform of claim 7 wherein the model of the platform-generated interference is pre-generated prior to receiving the signal by:

   operating the receiving platform;
   capturing at the receiving platform's antenna port the RF energy emitted during operation of the receiving platform; and,
   deriving a model for the platform-generated RF interference based upon statistical characteristics of the captured RF energy.

**10.** The wireless receiving platform of claim 7 further comprising a model selector for selecting one of a plurality of stored models of the platform-generated RF interference for tuning the model-based estimator based upon statistical characteristics of the baseband signal.

**11.** The wireless receiving platform of claim 10 wherein the plurality of stored models correspond to different operating modes of the receiving platform.

**12.** The wireless receiving platform of claim 10 wherein the models of the platform-generated interference are pre-generated prior to receiving the signal by:

   operating the receiving platform in each of a plurality of modes while no carrier waveform is being received, wherein each mode corresponds to a different stress pattern for operating the receiving platform;
   for each of the modes, capturing at the receiving platform's antenna port the RF energy emitted by the receiving platform; and,
   for each of the modes, deriving a model for the platform-generated RF interference based upon statistical characteristics of the captured RF energy.

**13.** The wireless receiving platform of claim 7 wherein the processing circuitry further includes:

   a partial classifier for, based upon statistical characteristics of the baseband signal, classifying the RF interference of the baseband signal into a model class selected from a plurality of model classes, wherein each model class includes one or more models of the platform-generated RF interference;
   circuitry for inputting the baseband signal into one or more interference mitigation paths in parallel where each such path includes a model-based estimator tuned to a model of the platform-generated RF interference belonging to the selected model class;

a model detector for comparing the output variance of each interference mitigation path and selecting the model of the platform-generated RF interference belonging to the interference mitigation path with the lowest output variance, wherein the processing circuitry is to generate an estimate of the platform-generated RF interference by filtering the baseband signal using a model-based estimator tuned to the selected model of the platform-generated RF interference.

**14.** The wireless receiving platform of claim 7 wherein the model of the platform-generated interference is at least partially based upon stochastic differential equations.

**15.** A computer readable medium including instructions that, when executed by a processor, causes the processor to perform operations comprising the methods recited by any of claims 1 through 6.

**Fig. 1**

Fig. 2

Fig. 3

s(t)

n(t)

i(t)

r(t)

**Downconversion and Digitization**

**100**

B(k)

301

Δ

**Model-based Estimator 321**

$E_1(k)$

301

Δ

**Model Selector 331**

M$_A$  M$_B$  M$_C$  M$_D$

**Interference Mitigation Path 1**

**Model Selector**

**360**

E(k)

301

Δ

**Model-based Estimator 32N**

$E_N(k)$

301

Δ

**Model Selector 33N**

M$_W$  M$_X$  M$_Y$  M$_Z$

**Interference Mitigation Path N**

**Model Detector**

**355**

**Partial Classifier**

**350**

**RF Interference Mitigation  200**

**Fig. 4**